# EUROPEAN PATENT APPLICATION

(11) **EP 2 408 023 A1**
(43) Date of publication of application: **18.01.2012**
(21) Application number: 10169889.2
(22) Date of filing: 16.07.2010
(51) Int. Cl.: H01L 31/18, H01L 31/0224, H01L 31/068, C23C 14/02, C23C 14/08, H01L 31/0236, H01L 31/0687, H01L 31/075, H01L 31/076, H01L 31/20

(54) **Thin-film Solar Fabrication Process, Deposition method for TCO layer, and Solar cell precursor layer stack**

(71) Applicant: Applied Materials, Inc., Santa Clara, CA 95054 (US)
(72) Inventor: Schmidt, Ursula Ingeborg, 63755, Alzenau (DE); Sommer, Elisabeth, 63755, Alzenau (DE); Vermeir, Inge, 91077, Neunkirchen (DE); Kress, Markus, 63165, Mühlheim (DE); Kuhr, Niels, 63739, Aschaffenburg (DE); Obermeyer, Philipp, 63741, Aschaffenburg (DE); Severin, Daniel, 63477, Maintal (DE); Supritz, Anton, 93326, Offenstetten (DE); Verhaverbeke, Steven, San Francisco, CA 94107 (US)
(74) Representative: Zimmermann & Partner

(57) **Abstract**

Methods of depositing a TCO layer on a substrate and precursor for solar cells are described. A method of depositing a TCO layer (404) on a substrate (102) includes providing a glass substrate having a first alkali metal concentration, conditioning the glass substrate, wherein the conditioning comprises at least one step selected from the group consisting of: applying a liquid to the substrate to form a layer with a second alkali metal layer concentration higher than the first alkali metal concentration, and depositing a layer to form a layer (402) with a second alkali metal layer concentration higher than the first alkali metal concentration, and depositing a TCO layer (404) over the conditioned substrate.

## Description

### BACKGROUND OF THE INVENTION

### Field of the Invention

Embodiments of the present invention generally relate to depositing TCO layers and texturing TCO layers, which are deposited on a conditioned substrate, particularly for a front contact surface of solar cells. Specifically, they relate to a method of depositing a TCO layer on a substrate and a precursor for a solar cell device.

### Description of the Related Art

Crystalline silicon solar cells and thin-film solar cells are two types of solar cells. Crystalline silicon solar cells typically use either monocrystalline substrates (i.e., single-crystal substrates of pure silicon) or multi-crystalline silicon substrates (i.e., poly-crystalline or polysilicon). Additional film layers are deposited onto the silicon substrates to improve light capture, form the electrical circuits, and protect the devices. Thin-film solar cells use thin layers of materials deposited on suitable substrates to form one or more p-n junctions. Suitable substrates include glass, metal, and polymer substrates.

To expand the economic uses of solar cells, efficiency must be improved. Solar cell stabilized efficiency relates to the proportion of incident radiation converted into usable electricity. For solar cells to be useful for more applications, solar cell efficiency must be improved beyond the current best performance of approximately 10% for Si based Thin-film solar modules. With energy costs rising, there is a need for improved thin-film solar cells and methods and apparatuses for forming the same in a factory environment.

In order to improve the efficiency of a solar cell, light trapping is one aspect that can be improved. In order to improve trapping of the photons surface texture at the light entering surface can be utilized.

Another aspect for improving mass production of solar cells is the use of large scale processes and the reliability at which processes can be conducted. Thus, there is a desire to improve the processes for increasing the efficiency on a large scale and for applications during industrial manufacturing.

### SUMMARY OF THE INVENTION

In light of the above, a method of depositing a TCO layer on a substrate according to independent claim 1 and a precursor for a solar cell according to independent claim 7 are provided.

Embodiments of the invention provide methods of depositing TCO layers and texturing TCO layers, which are deposited on a conditioned substrate. According to one embodiment a method of depositing a TCO layer on a substrate is provided. The method includes providing a glass substrate having a first alkali metal concentration and conditioning the glass substrate, wherein the conditioning comprises at least one step selected from the group consisting of: applying a liquid to the substrate to form a layer with a second alkali metal layer concentration higher than the first alkali metal concentration, and depositing a layer to form a layer with a second alkali metal layer concentration higher than the first alkali metal concentration. The method further includes depositing a TCO layer over the conditioned substrate.

According to another embodiment a method of depositing a TCO layer on a substrate is provided. The method includes providing a glass substrate and conditioning the glass substrate, wherein the conditioning includes at least one step selected from the group consisting of: cleaning the substrate or applying a liquid to the substrate to form an alkali metal-containing seed layer, and depositing a layer to form an alkali metal-containing seed layer. The method further comprises depositing a TCO layer over the conditioned substrate.
According to a yet further embodiment a precursor for a solar cell is provided. The precursor includes a glass substrate, an alkali metal-containing seed layer provided on the glass substrate, and a TCO layer deposited over the seed layer.

### BRIEF DESCRIPTION OF THE DRAWINGS

So that the manner in which the above recited features of the present invention are attained and can be understood in detail, a more particular description of the invention, briefly summarized above, may be had by reference to the embodiments thereof, which are illustrated in the appended drawings.

Figure 1 is a schematic side-view of a tandem junction thin-film solar cell according to one embodiment of the invention;

Figure 2 is a schematic side-view of a single junction thin-film solar cell according to one embodiment of the invention;

Figures 3A and 3B are schematic side-views of a front surface of a semiconductor precursor illustrating light trapping, which can for example be utilized for a solar cell.

Figures 4A to 4F illustrate the layers deposited on a substrate according to embodiments described herein;

Figure 5 is a schematic flow chart of a method of depositing a TCO on a substrate according to embodiments described herein;

Figures 6A to 6E illustrate a yet further embodiment of a layer stack of layers deposited on a substrate according to embodiments described herein;

Figure 7 is a schematic flow chart of a yet further method of depositing a TCO on a substrate according to embodiments described herein;

Figure 8 is a schematic side view illustrating an apparatus for depositing a layer stack according to embodiments described herein and for conducting a method according to embodiments described herein; and

Figures 9 and 10 are schematic side views illustrating a yet further apparatuses for depositing a layer stack according to embodiments described herein and for conducting a method according to embodiments described herein.

To facilitate understanding, identical reference numerals have been used, where possible, to designate identical or similar elements that are common to the figures. It is contemplated that elements and features of one embodiment may be beneficially incorporated into other embodiments without further recitation.

It is to be noted, however, that the appended drawings illustrate only exemplary embodiments of this invention and are therefore not to be considered limiting of its scope, for the invention may admit to other equally effective embodiments.

### DETAILED DESCRIPTION

Reference will now be made in detail to the various embodiments of the invention, one or more examples of which are illustrated in the figures. Each example is provided by way of explanation of the invention and is not meant as a limitation of the invention. For example, features illustrated or described as part of one embodiment can be used on or in conjunction with other embodiments to yield yet a further embodiment. It is intended that the present invention includes such modifications and variations.

The term "substrate" as used herein shall embrace both inflexible substrates, e.g. a wafer or a glass plate, and flexible substrates such as webs and foils.

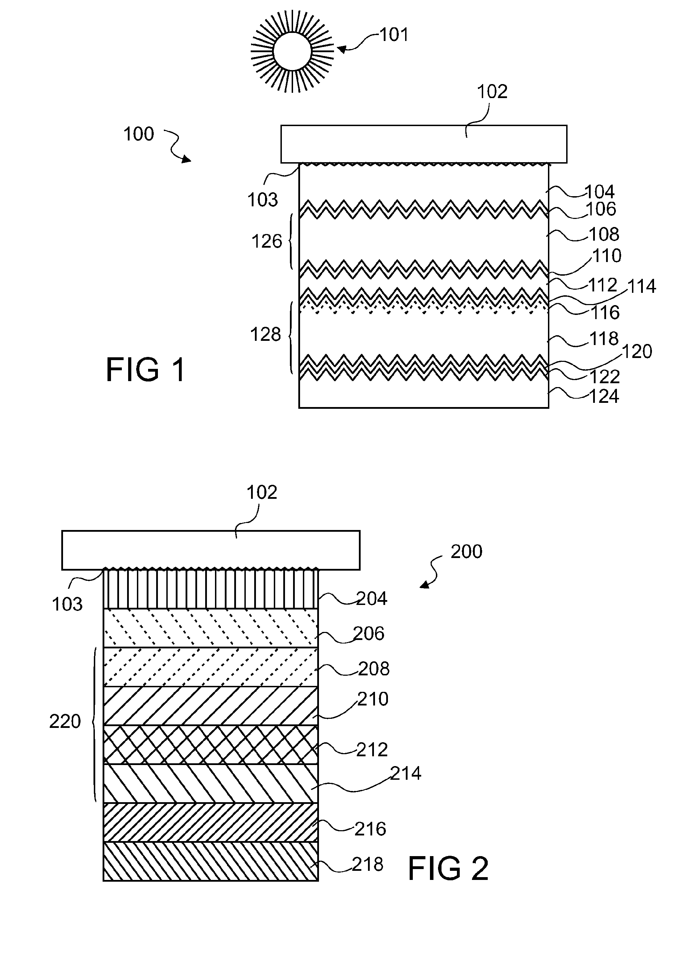

Embodiments described herein relate to processes for the etching of substrate precursors, a method of forming solar cells including etching of substrate precursors, devices for etching substrate precursors, and layer stacks for solar cells being based on substrate precursors with etching processes as described herein. Thereby, reference is for example made to the solar cells as described below and explained in further detail with respect to Figs. 1 and 2.

Thin-film solar cells are generally formed from numerous types of films, or layers, combined in many different ways. Most films used in such devices incorporate a semiconductor element that may comprise silicon, germanium, carbon, boron, phosphorous, nitrogen, oxygen, hydrogen and the like. Characteristics of the different films include degree of crystallinity, dopant type, dopant concentration, film refractive index, film extinction coefficient, film transparency, film absorption, and conductivity. Typically, most of these films can be formed by use of a chemical vapor deposition process, which may include some degree of ionization, plasma formation, and/or sputtering processes.

Sputtering is a process in which atoms are ejected from a solid target material due to the bombardment of the target by energetic particles. The process of coating a substrate as a material at the scraping refers typically to thin-film applications. The term "coating" and the term "depositing" are used synonymously herein. The terms "sputtering installation" and "deposition apparatus" are used synonymously herein and shall embrace for example an apparatus which uses sputtering for depositing a target material, typically as a thin-film, on a substrate. Typical target materials include (but are not limited to) pure metals such as aluminum (Al), copper (Cu), silver (Ag) and gold (Au), metal alloys such as an aluminum-niobium (AINb) alloy or an aluminum-nickel (AINi) alloy, semiconductor materials such as silicon (Si) and dielectric materials such as nitrides, carbides, titanates, silicates, aluminates and oxides, e.g. transparent conducting oxides (TCO) such as impurity-doped ZnO, In₂O₃, SnO₂ and CdO, as well as Sn doped In₂O₃ (ITO) and F doped SnO₂.

According to different embodiments, a plurality of films can be used in solar cells. Charge generation during a photovoltaic process is generally provided by a bulk semiconductor layer, such as a silicon-containing layer. The bulk layer is also sometimes called an intrinsic layer to distinguish it from the various doped layers present in the solar cell. The intrinsic layer may have any desired degree of crystallinity, which will influence its light-absorbing characteristics. For example, an amorphous intrinsic layer, such as amorphous silicon, will generally absorb light at different wavelengths from intrinsic layers having different degrees of crystallinity, such as microcrystalline silicon. For this reason, most solar cells will use both types of layers to yield the broadest possible absorption characteristics. In some instances, an intrinsic layer may be used as a buffer layer between two dissimilar layer types to provide a smoother transition in optical or electrical properties between the two layers.

Silicon and other semiconductors can be formed into solids having varying degrees of crystallinity. Solids having essentially no crystallinity are amorphous, and silicon with negligible crystallinity is referred to as amorphous silicon. Completely crystalline silicon is referred to as crystalline, polycrystalline, or monocrystalline silicon. Polycrystalline silicon is crystalline silicon formed into numerous crystal grains separated by grain boundaries. Monocrystalline silicon is a single crystal of silicon. Solids having partial crystallinity, that is a crystal fraction between about 5% and about 95%, are referred to as nanocrystalline or microcrystalline, generally referring to the size of crystal grains suspended in an amorphous phase. Solids having larger crystal grains are referred to as microcrystalline, whereas those with smaller crystal grains are nanocrystalline. It should be noted that the term "crystalline silicon" may refer to any form of silicon having a crystal phase, including microcrystalline and nanocrystalline silicon.

FIG. 1 is a schematic diagram of an embodiment of a multi-junction solar cell 100 oriented toward the light or solar radiation 101. Solar cell 100 comprises a substrate 102, such as a glass substrate, polymer substrate, metal substrate, or other suitable substrate, with thin-films formed thereover. The solar cell 100 further comprises a first transparent conducting oxide (TCO) layer 104 formed over the substrate 102, and a first p-i-n junction 126 formed over the first TCO layer 104. In one configuration, a wavelength selective reflector (WSR) layer 112 is formed over the first p-i-n junction 126. A second p-i-n junction 128 is formed over the first p-i-n junction 126, a second TCO layer 122 is formed over the second p-i-n junction 128, and a metal back layer 124 is formed over the second TCO layer 122. In one embodiment, a WSR layer 112 is disposed between the first p-i-n junction 126 and the second p-i-n junction 128, and is configured to have film properties that improve light scattering and current generation in the formed solar cell 100. Additionally, the WSR layer 112 also provides a good p-n tunnel junction that has a high electrical conductivity and a tailored bandgap range that affects its transmissive and reflective properties to improve the formed solar cell's light conversion efficiency.

To improve light absorption by enhancing light trapping, the substrate and/or one or more of the thin-films formed thereover may be optionally textured by wet, plasma, ion etching, and/or mechanical processes. For example, in the embodiment shown in FIG. 1, the first TCO layer 104 is textured and the subsequent thin-films deposited thereover will generally follow the topography of the surface below it.

Thereby, according to some embodiments described herein, the substrate 102 is conditioned to provide improved properties of the TCO layer, such as a ZnO-containing layer. The conditioning can include increasing a alkali metal content of the substrate before depositing the TCO layer. Thereby, nucleation of the TCO layer can be influenced to provide for improved texturing and to provide desired electrical and optical properties of the TCO layer. According to some embodiments, the conditioning can be conducted by depositing or preparing an alkali metal-containing seed layer 103.

The first TCO layer 104 and the second TCO layer 122 may each comprise tin oxide, zinc oxide, indium tin oxide, cadmium stannate, combinations thereof, or other suitable materials. It is understood that the TCO materials may also include additional dopants and components. For example, zinc oxide may further include dopants such as aluminum, gallium, boron, and other suitable dopants. Zinc oxide preferably includes 5 atomic % or less of dopants, and more preferably comprises 2.5 atomic % or less aluminum. In certain instances, the substrate 102 may be provided by the glass manufacturers with the first TCO layer 104 already provided.

The first p-i-n junction 126 may comprise a p-type amorphous silicon layer 106, an intrinsic type amorphous silicon layer 108 formed over the p-type amorphous silicon layer 106, and an n-type microcrystalline silicon layer 110 formed over the intrinsic type amorphous silicon layer 108. In certain embodiments, the p-type amorphous silicon layer 106 may be formed to a thickness between about 60Å and about 300Å. In certain embodiments, the intrinsic type amorphous silicon layer 108 may be formed to a thickness between about 1,500Å and about 3,500Å. In certain embodiments, the n-type microcrystalline semiconductor layer 110 may be formed to a thickness between about 100Å and about 400Å.

The WSR layer 112 disposed between the first p-i-n junction 126 and the second p-i-n junction 128 is generally configured to have certain desired film properties. In this configuration the WSR layer 112 actively serves as an intermediate reflector having a desired refractive index, or ranges of refractive indexes, to reflect light received from the light incident side of the solar cell 100. The WSR layer 112 also serves as a junction layer that boosts the absorption of the short to mid wavelengths of light (e.g., 280nm to 800nm) in the first p-i-n junction 126 and improves short-circuit current, resulting in improved quantum and conversion efficiency. Further, the WSR layer 112 has high film transmittance for mid to long wavelengths of light (e.g., 500nm to 1100nm) to facilitate the transmission of light to the layers formed in the junction 128. Further, it is generally desirable for the WSR layer 112 to absorb as little light as possible while reflecting desirable wavelengths of light (e.g., shorter wavelengths) back to the layers in the first p-i-n junction 126 and transmitting desirable wavelengths of light (e.g., longer wavelengths) to the layers in the second p-i-n junction 128.

In one embodiment, the WSR layer 112 may comprise an n-type doped silicon alloy layer, such as silicon oxide (SiOₓ, SiO₂) silicon carbide (SiC), silicon oxynitride (SiON), silicon nitride (SiN), silicon carbon nitride (SiCN), silicon oxycarbide (SiOC), silicon oxycarbon nitride (SiOCN), or the like. In an exemplary embodiment, the WSR layer 112 is an n-type SiON or SiC layer.

The second p-i-n junction 128 may comprise a p-type microcrystalline silicon layer 114 and, in some cases, an optional p-i buffer type intrinsic amorphous silicon (PIB) layer 116 that is formed over the p-type microcrystalline silicon layer 114. Subsequently, an intrinsic type microcrystalline silicon layer 118 is formed over the p-type microcrystalline silicon layer 114, and an n-type amorphous silicon layer 120 is formed over the intrinsic type microcrystalline silicon layer 118. In certain embodiments, the p-type microcrystalline silicon layer 114 may be formed to a thickness between about 100Å and about 400Å. In certain embodiments, the p-i buffer type intrinsic amorphous silicon (PIB) layer 116 may be formed to a thickness between about 50 Å and about 500 Å. In certain embodiments, the intrinsic type microcrystalline silicon layer 118 may be formed to a thickness between about 10,000Å and about 30,000Å. In certain embodiments, the n-type amorphous silicon layer 120 may be formed to a thickness between about 100Å and about 500Å.

The metal back layer 124 may include, but is not limited to a material selected from the group consisting of Al, Ag, Ti, Cr, Au, Cu, Pt, alloys thereof, or combinations thereof. Other processes may be performed to form the solar cell 100, such as one or more laser scribing processes. Other films, materials, substrates, and/or packaging may be provided over the metal back layer 124 to complete the solar cell device. The formed solar cells may be interconnected to form modules, which in turn can be connected to form arrays.

Solar radiation 101 is primarily absorbed by the intrinsic layers 108, 118 of the p-i-n junctions 126, 128 and is converted to electron-holes pairs. The electric field created between the p-type layer 106, 114 and the n-type layer 110, 120 that stretches across the intrinsic layer 108, 118 causes electrons to flow toward the n-type layers 110, 120 and holes to flow toward the p-type layers 106, 114 creating a current. The first p-i-n junction 126 comprises an intrinsic type amorphous silicon layer 108 and the second p-i-n junction 128 comprises an intrinsic type microcrystalline silicon layer 118 since amorphous silicon and microcrystalline silicon absorb different wavelengths of the solar radiation 101. Therefore, the formed solar cell 100 is more efficient, since it captures a larger portion of the solar radiation spectrum. The intrinsic layer 108, 118 of amorphous silicon and the intrinsic layer of microcrystalline silicon are stacked in such a way that solar radiation 101 first strikes the intrinsic type amorphous silicon layer 118 and is transmitted through the WSR layer 112 and then strikes the intrinsic type microcrystalline silicon layer 118 since amorphous silicon has a larger bandgap than microcrystalline silicon. Solar radiation not absorbed by the first p-i-n junction 126 continuously transmits through the WSR layer 112 and continues to the second p-i-n junction 128.

Charge collection is generally provided by doped semiconductor layers, such as silicon layers doped with p-type or n-type dopants. P-type dopants are generally group III elements, such as boron or aluminum. N-type dopants are generally group V elements, such as phosphorus, arsenic, or antimony. In most embodiments, boron is used as the p-type dopant and phosphorus as the n-type dopant. These dopants may be added to the p-type and n-type layers 106, 110, 114, 120 described above by including boron-containing or phosphorus-containing compounds in the reaction mixture. Suitable boron and phosphorus compounds generally comprise substituted and unsubstituted lower borane and phosphine oligomers. Some suitable boron compounds include trimethylboron (B(CH₃)₃ or TMB), diborane (B₂H₆), boron trifluoride (BF₃), and triethylboron (B(C₂H₅)₃ or TEB). Phosphine is the most common phosphorus compound. The dopants are generally provided with carrier gases, such as hydrogen, helium, argon, and other suitable gases. If hydrogen is used as the carrier gas, it adds to the total hydrogen in the reaction mixture. Thus hydrogen ratios will include hydrogen used as a carrier gas for dopants.

FIG. 2 is a schematic side-view of a double-junction thin-film solar cell 200 according to other embodiments of the invention, which might in some instances use a light trapping improvement. The embodiment of FIG. 2 differs from that of FIG. 1 by inclusion of a p-type crystalline silicon alloy layer 206 between the p-type amorphous silicon layer 208 and the first TCO layer 104 of FIG. 1. Alternatively, the p-type crystalline silicon alloy layer 206 may be a degeneratively doped layer having p-type dopants heavily doped in the alloy layer 206. The embodiment of FIG. 2 thus comprises the substrate 102 on which a conductive layer 204, such as a TCO layer similar to the first TCO layer 104 of FIG. 1, is formed. As described above, a p-type crystalline silicon alloy layer 206 is formed over the conductive layer 204. The p-type crystalline silicon alloy layer 206 has improved bandgap due to lower doping, an adjustable refractive index generally lower than that of a degeneratively doped layer, high conductivity, and resistance to oxygen attack by virtue of the included alloy components. A p-i-n junction 220 is formed over the p-type crystalline silicon alloy layer 206 by forming a p-type amorphous silicon layer 208, a PIB layer 210, an intrinsic amorphous silicon layer 212, and an n-type amorphous silicon layer 214. The solar cell 200 of FIG. 2 is completed, similarly to the foregoing embodiments, with an n-type crystalline silicon alloy layer 216, which is similar to the WSR layer 112 of FIG. 1, and a second conductive layer 218, which may be a metal or metal/TCO stack, similar to the conductive layers 122, 124 of FIG. 1.

According to different embodiments, a plurality of methods and system/apparatus configurations for texturing a semiconductor precursor can be utilized in embodiments described herein. As described above, the layers, particularly the TCO layer 104, are generally textured in order to improve light trapping and, thus, the efficiency of a solar cell. In the following, it is exemplarily referred to etching of zinc oxide (ZnO) layers as a front contact of precursors for a solar thin-film. However, the same principles can be applied to other semiconductor device manufacturing methods.

According to some embodiments described herein, the substrate 102 is conditioned to provide improved properties of the TCO layer, such as a ZnO-containing layer. The conditioning can include increasing a alkali metal content of the substrate before depositing the TCO layer. Thereby, nucleation of the TCO layer can be influenced to provide for improved texturing and to improve the desired electrical and optical properties of the TCO layer. According to some embodiments, the conditioning can be conducted by depositing or preparing an alkali metal-containing seed layer 103.

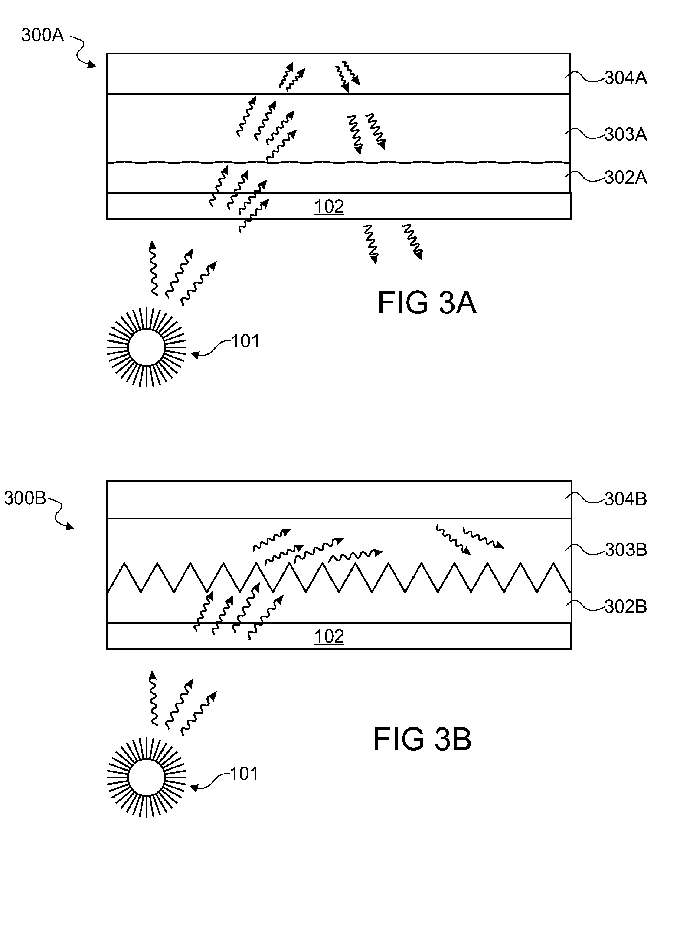

As illustrated with respect to FIGS. 3A and 3B, texturing of layers or films in the semiconductor device can, for example, improve light trapping. FIGS. 3A and 3B show the semiconductor device precursor 300A and 300B, respectively. Layers 302A, 303A, 304A and 302B, 303B, 303C, respectively, are deposited above the substrate 102. As shown in FIG. 3A, the layer 302 has a flat or almost flat upper surface. In light thereof, a portion of a radiation source 101, such as the sun for a solar cell device, can be reflected within the semiconductor device precursor. This is indicated by a portion of the photons being reflected at the upper surface of layer 304A in FIG. 3A. Thereby, the photons can leave the layer stack for a solar cell after a relative short path length. Contrary thereto, as shown in FIG. 3B, a textured surface 302B increases the likelihood of all, or at least 90 %, of the photons to enter the semiconductor device. Further, the photons are diffracted at the boundaries of the layers such that the photons might even remain in one layer by total internal reflection upon diffraction at the textured TCO layer. Thereby, the path length within the desired layer in which photons should be absorbed for light conversion is increased. This generally improves the efficiency of the layer stack for the solar cell.

According to embodiments described herein, an improved ZnO-containing TCO layer is deposited on an industrially-relevant scale. For example, the TCO layers of some embodiments described herein can be deposited on an area of 3 m² and above, 4 m² and above, or 5 m² and above. Thereby, the surface on which the ZNO-containing TCO layer is to be deposited is conditioned to provide a desired nucleation area for the desired film properties. According to typical examples, alkali metals, such as Na and K, can be found in the ZnO nucleation area. Typically, these elements, which may also, in some quantity, be included in the substrate itself, can provide a seed or a seed layer. Accordingly, the cleaning process, the choice of detergent for a cleaning process or a deposition step of a seed layer can be provided such that alkali metal-containing seeds are provided.

Thus, according to some embodiments described herein, alkali metal contamination can be introduced during a deposition step, or can remain on the substrate.

Thereby, according to different alternatives, the alkali metal-containing seeds or the desired alkali metal concentration can be provided on the substrate before or after cleaning, on a barrier layer or by a barrier layer, which is deposited between the substrate and the TCO layer.

Embodiments described herein are thereby generally related to the front contact, particularly of a thin-film solar cell, such as a silicon thin-film solar cell. Further, seeds or a seed layer is provided due to the cleaning of the flat glass substrates, e.g. by means of the detergent, or due to deposition of the seeds or the seed layer.

The inventors have found, that the structure or cleanliness with regard to the alkali metal concentration of the surface to be coated with the ZnO-containing layer influences the growth structure of the ZnO-containing layer. Thereby, a different ZnO structure after the texturing, e.g. by an etching step, can be provided. Thereby, optimizing the nucleation of the ZnO layer also needs to take into account the electrical and optical properties of the TCO layer in order to realize high efficiency of a solar cell module, improved light trapping, long lifetime under environmental conditions, cost-effectiveness and repeatability of manufacturing, and the like.

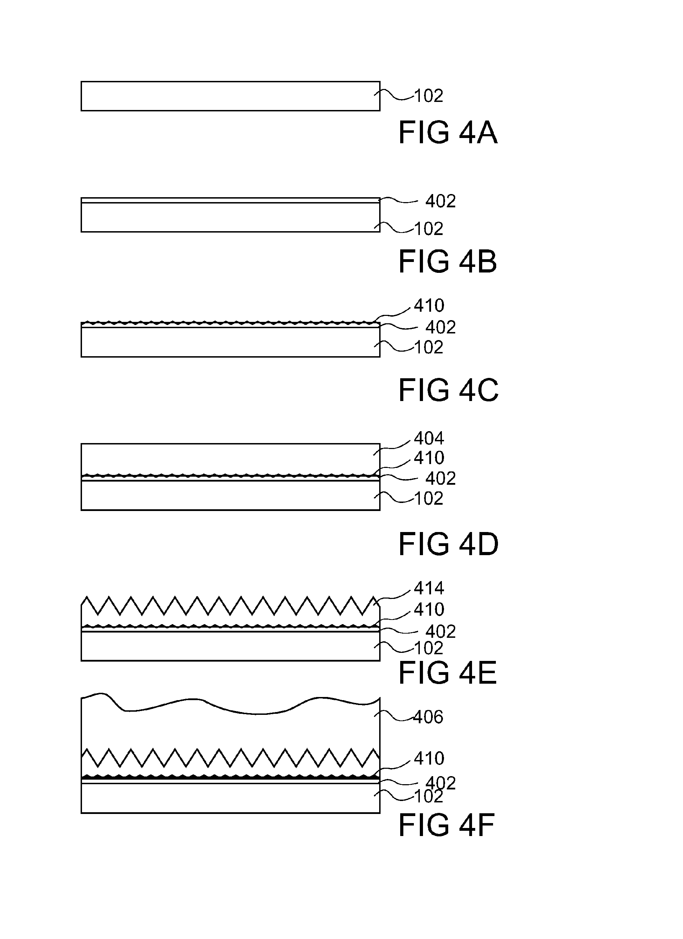

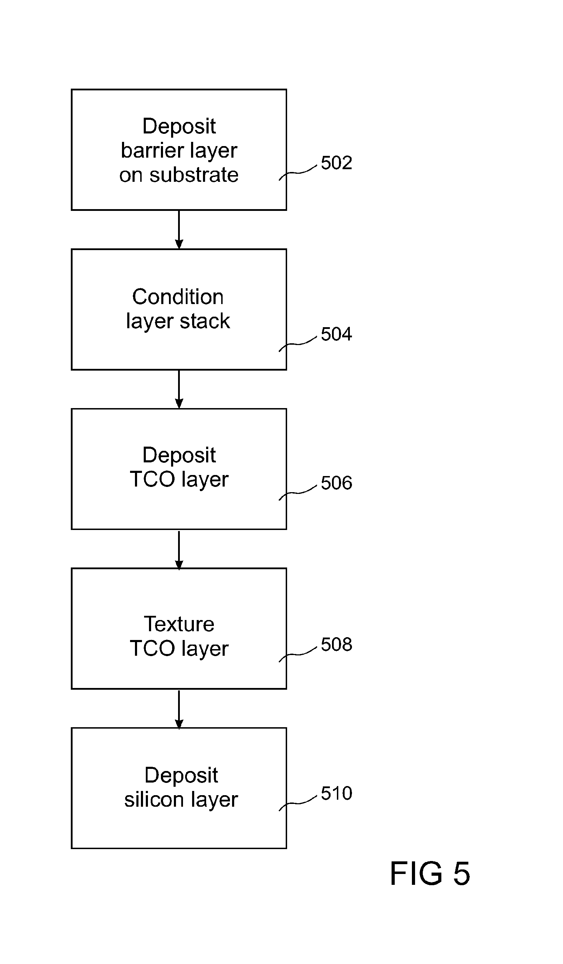

Typical embodiments are, for example, shown in FIGS. 4A to 4F, which are described in the following while referring to the method illustrated in FIG. 5. FIG. 4A shows a substrate 102 which can be provided for depositing a TCO layer. According to some embodiments, the TCO layer can be used as a front contact layer of a thin-film solar cell. In step 502 a barrier layer is deposited on the substrate. This is illustrated by layer 402 shown in FIG. 4B. As shown in FIG. 4C, the barrier layer 402 is conditioned such that a seed layer 410 or corresponding seeds are provided on the barrier layer.

Thereby, according to different embodiments, which can be used alternatively to each other or in combination with each other, the conditioning step 504 provides a defined concentration of alkali metals on the surface on which the zinc oxide layer 404 (see FIG. 4D) is deposited. Typically, the alkali metal concentration can be provided during the deposition step of the barrier layer 402, during a cleaning step of the substrate 102, on which the barrier layer 402 might or might not be deposited, and combinations thereof. Thereby, the alkali metal-containing seed layer 410 can have a thickness of 5 nm or below or can be even less than 1 nm. Accordingly, even though reference is made to a layer 410, the seed layer might not be a fully closed layer but might be a plurality of seeds or seed islands. It is to be understood that a thin layer with a thickness of only a few atoms will not continuously grow over the entire surface. Typically, the nucleation of a layer starts at several positions on a surface and a few atomic layers might build up in areas around those positions before the entire layer covers the surface to be coated. Thus, according to embodiments described herein, a seed layer might not necessarily fully cover the surface below.

According to yet further embodiments, the alkali metal can be sodium, potassium, or mixtures thereof. Thereby, typically the alkali metal element concentration, particularly the Na concentration, in the layer can be increased by at least 50%, typically by at least 100%, i.e. the number of alkali metal atoms is increased by at least 50%, typically by at least 100%. According to yet further alternative for additional embodiments, alkali metal atoms can be present at the conditioned surface with 1x10¹³ to 1x10¹⁸ atoms per cm2_{.}

After the layer stack has been conditioned in step 504, the TCO layer, typically a ZnO-containing layer, is deposited on the layer stack. Accordingly, the solar cell precursor shown in FIG. 4D is provided after step 506. In step 508, the TCO layer is textured resulting in the solar cell precursor shown in FIG. 4E.

According to some embodiments, which can be combined with other embodiments described herein, the solar cell precursors, the methods and devices for etching semiconductor device precursors, such as solar cell precursors, can be utilized for large area thin-films. For example, substrate sizes of 1.43 m² (Gen5) and above such as 5.7 m² (Gen8.5) or larger can be realized. Further typical embodiments relate to aluminum doped zinc oxide layers (ZnO:Al) as a TCO, which can be sputtered from rotatable ceramic zinc oxide aluminum oxide (ZnO:A1203) targets. Typically, the aluminum doped zinc oxide layers form a front contact of a solar cell. According to yet further embodiments, the TCO layer can be wet-chemically etched, for example in diluted hydrochloric acid, or other suitable etchants. Thereby, as described above, the etching process is of importance for the surface texture, which is used to scatter the light, particularly the long wavelength light in the VIS and NIR range.

Typically, the shape and feature size of the etched semiconductor layer depends on the parameters of the layer as well as the etching process. Accordingly, for a predetermined semiconductor layer with certain characteristics, the nucleation of the layer to be etched needs to be controlled such that the desired texture of the layer is generated.

According to different embodiments, the texturing can be conducted by a wet etching process or a dry etching process. According to yet further implementations, the etching process can be an isotropic or an anisotropic etching process. Typically, the texturing step 508 can be provided by etching the zinc oxide-containing TCO layer with a diluted acid in order to roughen the ZnO surface by wet etching. Thereby, as described with respect to FIGS. 3A and 3B, a specific haze is desired in order to improve light trapping of the layer stack for manufacturing a thin-film solar cell.

After texturing the TCO layer in step 508, a silicon layer 406 is deposited in step 510. According to typical embodiments, the silicon layer can be a p-type silicon layer, for example a p-type amorphous silicon layer 106 shown in FIG. 1. Alternatively, a p-type crystalline silicon layer 206 shown in FIG. 2 can be deposited on the textured TCO layer 414. Generally, one or more p-n-junctions are deposited on the TCO layer. Thereby, the textured TCO layer 414 forms the front contact of a precursor of a thin-film solar cell.

Generally, glass has a high sodium (Na) concentration and a low potassium (K) concentration. On the glass surface of the substrate, in comparison to the glass volume, the Na concentration is depleted near the surface and can be increased within the first few nm of an untreated glass substrate. By conditioning the layer stack before deposition of the ZnO-containing TCO layer 404, i.e. by providing the seeds or the seed layer 410, an alkali metal-containing layer is provided over the surface of a standard glass substrate, wherein the alkali metal layer concentration is higher as compared to the surface concentration of the glass substrate without the conditioning step.

Thereby, according to typical embodiments, which can be combined with other embodiments described herein, the Na and the K concentration can be increased. In the event of an untreated glass substrate, particularly the K concentration can be increased by at least 50%, typically by at least 100%, whereas the Na concentration might be increased to a smaller degree. Yet further, if the glass substrate is polished such that the alkali element concentration corresponds to the concentration of the depletion zone before conditioning of the substrate, both the Na and the K concentration can be increased by at least 50%, typically by at least 100%.

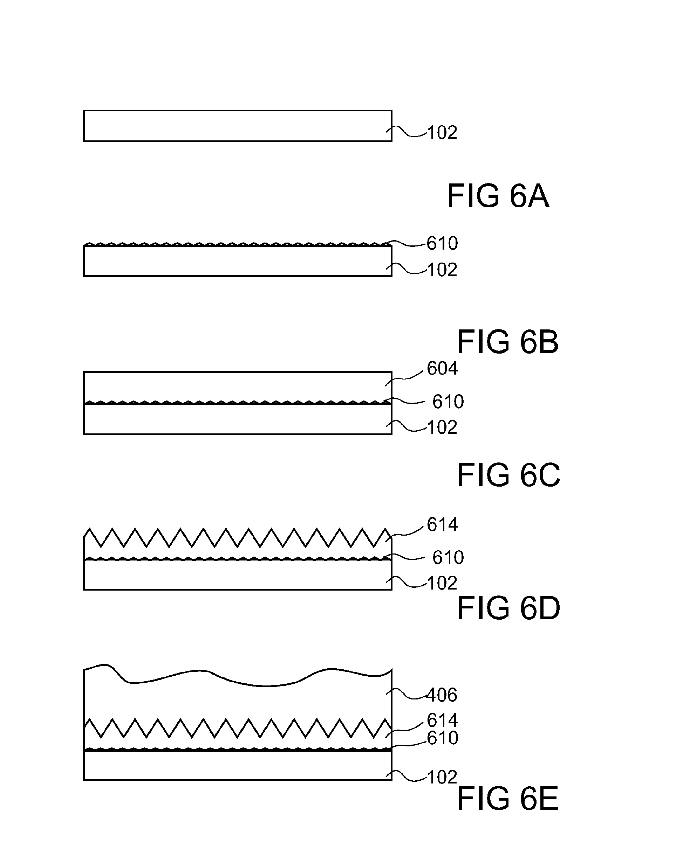

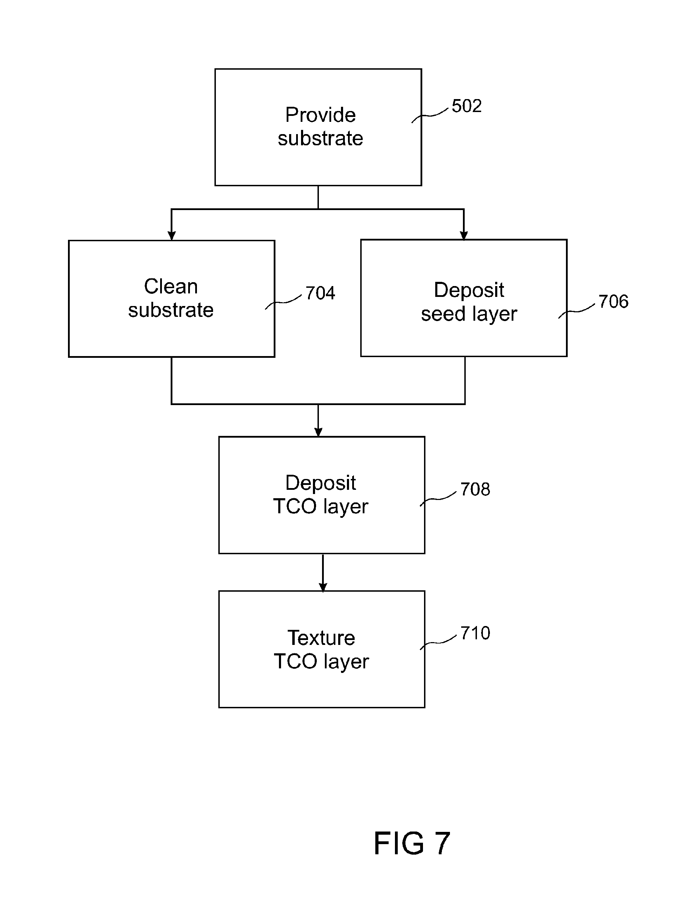

According to yet further embodiments, which are illustrated in FIGS. 6A to 6D and the flowchart shown in FIG. 7, a substrate 102 can be provided in step 702. In steps 704 or 706, respectively, the conditioning of the substrate 102 in order to provide the desired alkali metal concentration can be provided without a previously deposited barrier layer. Thereby, a seed layer 610 is provided on the substrate 102 as shown in FIG. 6B. According to alternative or additional embodiments, the seeds or the seed layer can be provided by cleaning the substrate (see step 704) or by depositing the seeds or the seed layer (see step 706).

According to one embodiment, conditioning of the surface on which the zinc oxide-containing TCO layer is to be deposited can be provided by cleaning the substrate or the layer stack with a detergent. Typically, the detergent for cleaning the substrate can be an alkali base and can, for example, include sodium hydroxide and/or potassium hydroxide. Thereby, the alkali metal concentration on the surface on which the TCO layer is to be deposited is increased and can be controlled.

According to further additional or alternative modifications, the alkali metal-containing seed layer 610 can also be deposited on the substrate 102 as shown in step 706. According to yet further embodiments, the alkali metal can be sodium, potassium, or mixtures thereof. Thereby, typically the alkali metal element concentration, particularly the Na concentration, in the layer can be increased by at least 50%, typically by at least 100%, i.e. the number of alkali metal atoms is increased by at least 50%, typically by at least 100%. According to yet further alternative for additional embodiments, alkali metal atoms can be present at the conditioned surface with 1x10¹³ to 1x10¹⁸ atoms per cm².

In step 708 the zinc oxide-containing TCO layer is deposited, which results in the TCO layer 604 shown in FIG. 6C. According to some embodiments, which can be combined with other embodiments described herein, this can be utilized for wet etching of metal oxides, such as zinc oxide. Thereby, according to some embodiments, which can be combined with other embodiments described herein, a layer thickness of 400 - 1200 nm of a semiconductor layer to be etched can be provided.

The nucleation of the TCO layer on the conditioned surface is such that a texturing step 710 results in the textured TCO layer 614, which provides sufficient haze for light trapping. This is, for example, advantageous for the efficiency of a thin-film solar cell.

According to different embodiments, the texturing can be conducted by a wet etching process or a dry etching process. According to yet further implementations, the etching process can be an isotropic or an anisotropic etching process. Typically, the texturing step 508 can be provided by etching the zinc oxide-containing TCO layer with a diluted acid in order to roughen the ZnO surface by wet etching. Thereby, as described with respect to FIGS. 3A and 3B, a specific haze is desired in order to improve light trapping of the layer stack for manufacturing a thin-film solar cell.

After texturing the TCO layer in step 710, a silicon layer 606 is deposited. According to typical embodiments, the silicon layer can be a p-type silicon layer, for example a p-type amorphous silicon layer 106 as shown in FIG. 1. Alternatively, a p-type crystalline silicon layer 206 as shown in FIG. 2 can be deposited on the textured TCO layer 614. Generally, one or more p-n-junctions are deposited on the TCO layer. Thereby, the textured TCO layer 614 forms the front contact of a precursor of a thin-film solar cell.

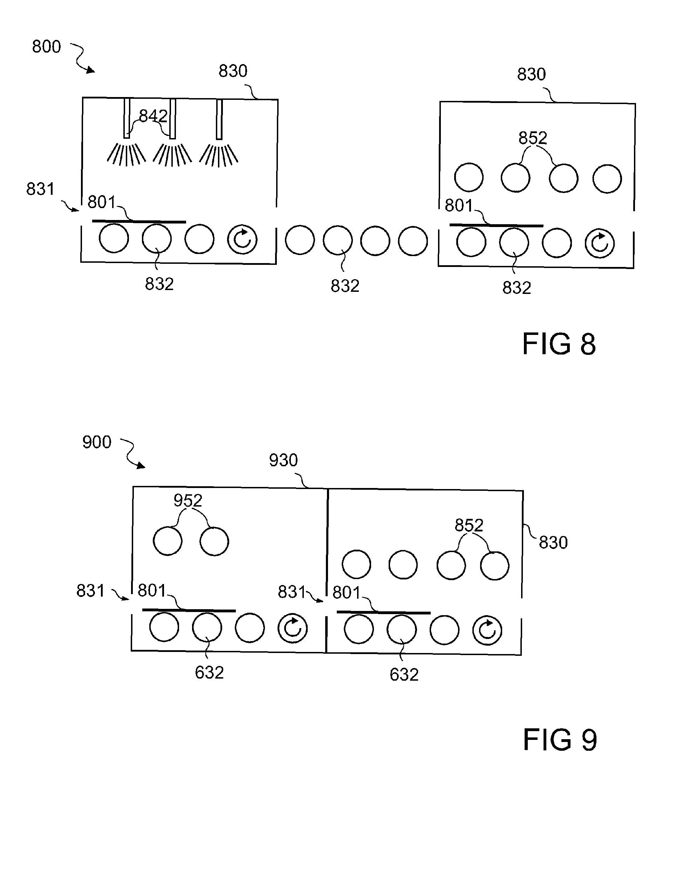

FIG. 8 illustrates an apparatus for depositing a TCO layer according to embodiments described herein. The apparatus 800 includes two or more chambers 830 or respective compartments. A transport system with, for example, rollers 832 for transporting a substrate 801 through the system 800 is provided. Typically, the chambers have openings 831 for introducing the substrate 801 into the chamber and transferring the substrate into a subsequent chamber or out of the chamber. According to typical embodiments, the openings 831 can be sealed with valves during operation of the system 800.

As shown in FIG. 8, nozzles 842 for spraying a detergent on the substrate 801 can be provided in the first chamber of the chambers 830. According to alternatives embodiments, the cleaning step with a detergent can also be conducted in a bath. The substrate or the layer stack being cleaned in the left chamber of the system 800 shown in FIG. 8, is conditioned with alkali metal seeds or an alkali metal seed layer, is transported towards the second chamber 830, whereby for example a drying process might be conducted, and is transferred into the second chamber 830. The second chamber includes sputtering cathodes 852, such as rotatable sputtering cathodes, for sputtering the TCO layer, such as a zinc oxide layer, on the substrate 801. Thereby, a TCO layer, which can be textured in the subsequence processing step such as a wet etching step, is deposited over the substrate.

FIG. 9 illustrates a yet further embodiment of an apparatus for depositing a TCO layer according to embodiments described herein. The apparatus 900 includes two or more chambers 930 and 830, or respective compartments. A transport system with, for example, rollers 832 for transporting a substrate 801 through the system 800 is provided. Typically, the chambers have openings 831 for introducing the substrate 801 into the chamber and transferring the substrate into a subsequent chamber or out of the chamber. According to typical embodiments, the openings 831 can be sealed with valves during operation of the system 800. As shown in FIG. 9, in the first chamber of the chambers 830, sputter cathodes 952, such as rotatable sputter cathodes can be provided to deposit a barrier layer or a seed layer, such that an alkali metal concentration is controlled and increased as compared to the surface concentration of the glass substrate. According to alternative implementations, the seeds or the seed layer can also be provided by a CVD process, such as a PECVD process. After the substrate or the layer stack has been conditioned in the left chamber of the system 900 shown in FIG. 9 with alkali metal seeds or an alkali metal seed layer, the substrate is transferred in the second chamber 830. The second chamber includes sputtering cathodes 852, such as rotatable sputtering cathodes, for sputtering the TCO layer, such as a zinc oxide layer, on the substrate 801. Thereby, a TCO layer, which can be textured in the subsequent processing step such as a wet etching step, is deposited over the substrate.

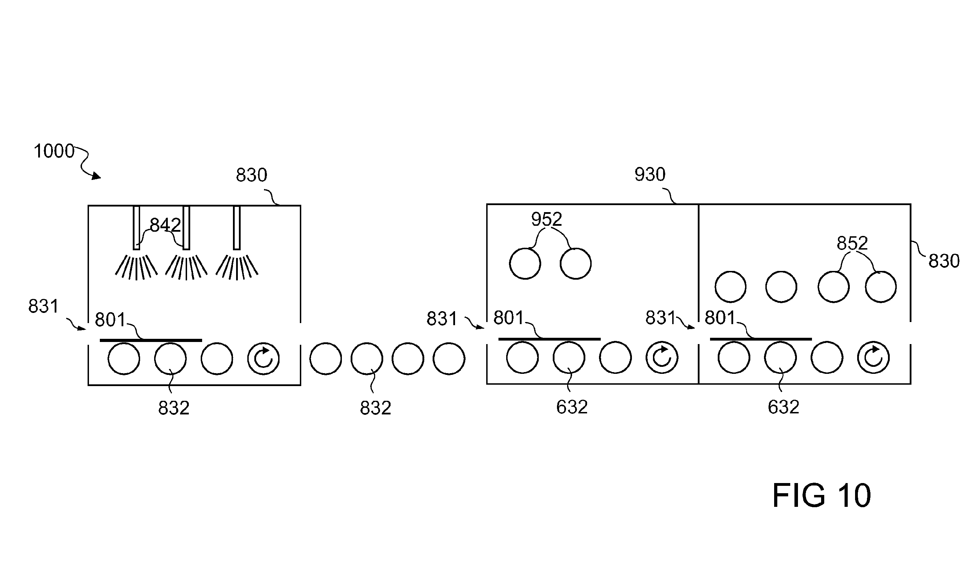

As shown in FIG. 10, nozzles 842 for spraying a detergent on the substrate 801 can be provided in the first chamber of the chambers 830. According to alternatives embodiments, the cleaning step with a detergent can also be conducted in a bath. The substrate or the layer stack being cleaned in the left chamber of the system 800 shown in FIG. 8, is conditioned with alkali metal seeds or an alkali metal seed layer, is transported towards the second and third chamber 830, whereby for example a drying process might be conducted, and is transferred into the second chamber 830. The second chamber includes sputtering cathodes 852, such as rotatable sputtering cathodes, for sputtering. For example, a barrier layer such as a SiON barrier layer, which can be reactively sputtered, can be provided on the conditioned substrate in the second chamber 930. Therefater, the TCO layer, such as a zinc oxide layer, is DC sputtered on the barrier layer. Thereby, a TCO layer, which can be textured in the subsequence processing step such as a wet etching step, is deposited over the substrate.

As described above, the systems 800, 900 and 1000 can further have a polishing station such that the first 5-20 nm of the substrate are removed in a polishing step before the substrate is condition with an alkali-metal seed layer according to embodiments described herein.
In light of the above, a plurality of embodiments has been described. According to one embodiment, a method of depositing a TCO layer on a substrate is provided. The method includes providing a glass substrate having a first alkali metal concentration, conditioning the glass substrate, wherein the conditioning comprises at least one step selected from the group consisting of: applying a liquid to the substrate to form a layer with a second alkali metal layer concentration higher than the first alkali metal concentration, and depositing a layer to form a layer with a second alkali metal layer concentration higher than the first alkali metal concentration, and depositing a TCO layer overthe conditioned substrate. According to modifications thereof, the cleaning can further include partly removing contaminants to expose alkali metal-containing seeds of the seed layer, and/or cleaning the glass substrate with a detergent-containing alkali metal-containing seeds; the alkali metal-containing seed layer can be formed on the glass substrate; and/or the method can further includes etching the TCO layer, wherein the etching is adapted to texture the TCO layer. According to yet further embodiments, which can be combined with other embodiments described herein, the TCO layer can be a ZnO-containing layer; the method can further include depositing a barrier layer between the conditioned glass substrate and the TCO layer, particularly wherein the barrier layer is a SiON containing layer; and/or the method can further include polishing the glass substrate before conditioning the glass substrate. According to yet further implementations, which can be combined with other modifications described herein, the number of alkali metal atoms is increased by at least 50%, typically by at least 100%.For example, the number of at least one element selected from the group of: sodium and potassium is increased.

According to another embodiment, a method of manufacturing a precursor for a solar cell is provided. The method includes depositing a TCO layer on a substrate according the embodiments described herein, depositing a layer stack including at least one p-n-junction over the TCO layer, and depositing a back contact layer.

According to yet another embodiment, a precursor for a solar cell is provided. The precursor includes a glass substrate, a alkali metal-containing seed layer provided on the glass substrate, and a TCO layer deposited over the seed layer. According to modifications thereof, the precursor can further include at least one p-n-junction having several doped semiconductor material layers and a back contact layer. According to yet further additional or alternative modifications, the alkali-metal-containing seed layer can include at least one element selected from the group consisting of Na, K and mixtures thereof; the alkali-metal-containing seed layer can have a thickness of less than 1 nm; the glass substrates can have a first alkali metal concentration within the glass material and the seed layer can have an second alkali metal concentration higher than the first alkali metal concentration; and/or the alkali-metal-containing seed layer can include a number of alkali metal atoms of 1x1013 to 1x1018 atoms per cm².

Aside from the better light scattering properties after etching, the improved nucleation of the ZnO can also lead to a higher conductivity and reduced absorption since the overall film quality is improved

While the foregoing is directed to embodiments of the present invention, other and further embodiments of the invention may be devised without departing from the basic scope thereof, and the scope thereof is determined by the claims that follow.

## Claims

1. A method of depositing a TCO layer on a substrate, the method comprising:
providing a glass substrate (102; 801) having a first alkali metal concentration;
conditioning the glass substrate, wherein the conditioning comprises at least one step selected from the group consisting of: applying a liquid to the substrate to form a layer with a second alkali metal layer concentration higher than the first alkali metal concentration, and depositing a layer to form a layer with a second alkali metal layer concentration higher than the first alkali metal concentration; and
depositing a TCO layer (104; 204; 404; 604) over the conditioned substrate.

2. The method according to claim 1, wherein the cleaning further comprises:
partly removing contaminants to expose alkali metal-containing seeds of the seed layer, and/or cleaning the glass substrate with a detergent-containing alkali metal-containing seeds.

3. The method according to any of claims 1 to 2, wherein the alkali metal-containing seed layer is formed on the glass substrate.

4. The method according to any of claims 1 to 3, further comprising:
etching the TCO layer, wherein the etching is adapted to texture the TCO layer (414; 614).

5. The method according to any of claims 1 to 4, wherein the TCO layer is a ZnO-containing layer.

6. The method according to any of claims 1 to 5, further comprising:
depositing a barrier layer (402) between the conditioned glass substrate and the TCO layer, particularly wherein the barrier layer is a SiON containing layer.

7. The method according to any of claims 1 to 6, further comprising:
polishing the glass substrate (102; 801) before conditioning the glass substrate.

8. The precursor according to any of claims 1 to 7, wherein the number of alkali metal atoms is increased by at least 50%, typically by at least 100%.

9. A method of manufacturing a precursor for a solar cell, the method comprising:
depositing a TCO layer on a substrate according to any of claims 1 to 8,
depositing a layer stack (126, 112, 128; 220) including at least one p-n-junction over the TCO layer, and
depositing a back contact layer (124; 218).

10. A precursor for a solar cell, comprising:
a glass substrate (102; 801);
a alkali metal-containing seed layer provided on the glass substrate; and
a TCO layer (104; 204; 404; 604) deposited over the seed layer.

11. The precursor according to claim 10, further comprising:
at least one p-n-junction (126, 128; 220) having several doped semiconductor material layers; and
a back contact layer (124; 218).

12. The precursor according to any of claims 10 to 11, wherein the alkali-metal-containing seed layer comprises at least one element selected from the group consisting of Na, K and mixtures thereof.

13. The precursor according to any of claims 10 to 12, wherein the alkali-metal-containing seed layer has a thickness of less than 1 nm.

14. The precursor according to any of claims 10 to 13, wherein the glass substrates (129; 801) has a first alkali metal concentration within the glass material and the seed layer has an second alkali metal concentration higher than the first alkali metal concentration.

15. The precursor according to any of claims 9 to 14, wherein the alkali-metal-containing seed layer comprises a number of alkali metal atoms of 1x10¹³ to 1x10¹⁸ atoms per cm².
